# EUROPÄISCHE PATENTSCHRIFT

(11) **EP 0 523 374 B1**
(45) Veröffentlichungstag und Bekanntmachung des Hinweises auf die Patenterteilung: **12.03.1997**
(21) Anmeldenummer: 92109918.0
(22) Anmeldetag: 12.06.1992
(51) Int. Cl.: H02H 9/02

(54) **Resistiver Strombegrenzer**
Resistive current limiter
Limiteur de courant resistif

(30) Priorität: 18.06.1991 DE 4119984
(43) Veröffentlichungstag der Anmeldung: 20.01.1993
(73) Patentinhaber: HOECHST AKTIENGESELLSCHAFT, 65926 Frankfurt am Main (DE)
(72) Erfinder: Abeln, Angelika, Dr., W-6940 Weinheim (DE); Dersch, Helmut, Dr., W-7820 Titisee/Neustadt (DE); Preisler, Eberhard, Dr., W-5042 Erftstadt (DE); Bock, Joachim, Dr., W-5042 Erftstadt (DE)

(56) Entgegenhaltungen:
- EP-A- 0 181 496
- EP-A- 0 315 976
- EP-A- 0 345 767
- EP-A- 0 350 916
- DD-A- 110 985

## Beschreibung

Die Erfindung bezieht sich auf einen resistiven Strombegrenzer mit wenigstens einem den Nennstrom tragenden Leiter aus Hochtemperatur-Supraleiter-Material, wobei die elektrisch wirksame Länge des Leiters um mindestens das Dreifache größer ist als seine lineare Ausdehnung.

Strombegrenzer dieser Art sind seit vielen Jahren bekannt. Sie weisen wenigstens einen Leiter aus supraleitendem Material auf, der in der Lage ist, Nennströme von vielen Ampere zu tragen. Strombegrenzer dieser Art können wegen der starken Widerstandsänderung während des Überganges vom supraleitenden in den normalleitenden Zustand für Schaltzwecke in diesem Bereich verwendet werden (vergl. die Informationsschrift "Theoretische und experimentelle Untersuchungen über die Eigenschaften eines großen supraleitenden Gleichstrombegrenzers mit 40 MW Schaltleistung bei einer Spannung von 47 kV", Kernforschungszentrum Karlsruhe KfK 2672 (1978). Wegen seines verschwindenden elektrischen Widerstands verursacht das supraleitende Material des Strombegrenzers keinerlei ohmsche Verluste. Da dieser Zustand nur unterhalb der kritischen Temperatur T_{c}, dem kritischen Strom und dem kritischen Magnetfeld auftritt, kann das supraleitende Material eines Strombegrenzers aus dem supraleitenden Zustand durch Überhöhung eines dieser Parameter über den kritischen Wert hinaus in einen resistiven Zustand übergeführt werden. Solche Strombegrenzer sind in der Lage, Ströme auf einen Reststrom zu begrenzen, der dann mit Hilfe eines Reststromschalters abgeschaltet werden kann. Wegen des relativ geringen elektrischen Widerstandes des supraleitenden Materials oberhalb der kritischen Temperatur T_{c} ist für eine optimale Strombegrenzung ein sehr langer Leiter erforderlich. der induktivitätsarm in einem möglichst kleinen Volumen untergebracht werden muß.

Die DD-A-110 985 beschreibt eine Wicklung für eine supraleitende Strombegrenzung, bei der ein Leiter, der aus verseilten Multifilamentleitern aus harten Supraleitern (metallische Tieftemperatursupraleiter) besteht, unter Zwischenlage von mehreren Isolierplatten mit Hilfe von Führungsbolzen zu einem Paket verspannt ist.

Der Erfindung liegt die Aufgabe zugrunde, einen resistiven Strombegrenzer anzugeben, der für die Begrenzung von großen und kleinen Strömen geeignet und zudem klein dimensioniert ist.

Diese Aufgabe wird bei einem resistiven Strombegrenzer gemäß dem Oberbegriff des Anspruchs 1 erfindungsgemäß durch die kennzeichnenden Merkmale des Anspruchs 1 gelöst.

Der erfindungsgemäße resistive Strombegrenzer kann auch wahlweise dadurch weitergebildet sein, daß
a) die Platte eine orthogonale Form aufweist und die Platte zur Ausbildung des Leiters mit Schlitzen versehen ist, welche in definiertem Abstand parallel und alternierend zueinander in die beiden zur Längsachse der Platte verlaufenden Seiten geschnitten sind,
b) das zur Fertigung des Leiters verwendete Hochtemperatur-Supraleiter-Material ein polynäres Oxid ist, das Bismut, Calcium, Strontium, Kupfer und gegebenenfalls Blei enthält,
c) daß der Leiter aus Bi₂Sr₂CaCu₂0₈ besteht,
d) daß der Leiter aus Bi₂Sr₂Ca₂Cu₃0₁₀ besteht,
e) der Leiter aus einem Hochtemperatur-Supraleiter-Material in Form eines polynären Oxids besteht, das Yttrium und/oder ein Seltenerdmetall sowie Barium und Kupfer enthält,
f) daß der Leiter aus YBa₂Cu₂0_{6,9} besteht ,
g) daß der Leiter aus NbTi besteht,
h) daß der Leiter aus Nb₃Sn besteht,
i) daß der Leiter aus Chevrel-Phasen besteht.

Der stromtragende Leiter des resistiven Strombegrenzers ist aus einem Hochtemperatur-Supraleiter-Material gefertigt. Vorzugsweise wird als supraleitendes Material ein polynäres Oxid verwendet. Besonders geeignet hierfür ist Yttrium-Barium-Kupferoxid bzw. Wismutcuprat, wobei letzteres Bleizusätze aufweisen kann. Es können auch keramische Materialien mit supraleitenden Eigenschaften verwendet werden, die anstelle von Yttrium ein anderes oder ein zusätzliches Seltenerdmetall enthalten. Ebenso kommen für die Fertigung des Leiters NbTi, Nb₃Sn oder Chevrel-Phasen in Frage.

Durch die spezielle Ausbildung des Leiters kann seine elektrisch wirksame Länge wesentlich vergrößert werden, während seine lineare Ausdehnung einen vorgebbaren Wert nicht überschreitet. Die elektrisch wirksame Länge des Leiters, sein Querschnitt und der senkrechte Abstand jeweils zweier benachbarter Leiterabschnitte sind so bemessen, daß beim Überschreiten der kritischen Stromdichte der sich im supraleitenden Material oberhalb der Sprungtemperatur T_{c} einstellende ohmsche Widerstand eine Größe aufweist, die eine Minderung des fließenden Stroms auf einen definierten Wert bewirkt.

Der Leiter kann erfindungsgemäß aus einer supraleitenden, orthogonalen Platte gefertigt werden. In die zur Längsachse der Platte parallel verlaufenden Seiten wird eine definierte Anzahl von Schlitzen eingeschnitten, die senkrecht zur Längsachse der Platte verlaufen. Die Schlitze werden alternierend in diese beiden Längsseiten eingeschnitten. Hierdurch wird aus der Platte ein mäanderförmiger Leiter gebildet, Die Enden des so gebildeten Leiters werden mit je einem elektrischen Anschlußpol versehen.

Es besteht auch die Möglichkeit, in derOberfläche eines Trägers eine mäanderförmige Nut auszubilden. Die Abmessungen der Nut sind gemäß den obigen Angaben für den Leiter festgelegt. Der Träger kann aus einem metallischen oder isolierenden Material gefertigt sein. Im Fall eines metallischen Trägers wird dieNut zunächst mit einem isolierenden Material ausgekleidet und dann mit dem suDraleitenden Material ausgefüllt.

Bei einem anderen Ausführungsbeispiel des erfindungsgemäßen Strombegrenzers wird eine Hülse aus Metall, vorzugsweise aus Silber oder Kupfer, mit einem supraleitenden metallischen oder keramischen Material ausgefüllt. Anschließend wird die Hülse gewalzt und gezogen, so daß ihr Querschnitt dem des zu bildenden Leiters entspricht. Anschließend wird die Hülse mäanderförmig gebogen, so daß ein Strombegrenzer entsteht, dessen Leiter die geforderten Abmessungen aufweist.

Der erfindungsgemäße resistive Strombegrenzer verliert beim Überschreiten einer kritischen Stromstärke seine supraleitenden Eigenschaften und wird zu einem ohmschen Widerstand.

Wegen der speziell gewählten Abmessungen seiner elektrisch wirksamen Länge kehrt er aber in den supraleitenden Zustand zurück, sobald durch ihn kein überkritischer Strom mehr fließt.

Die Erfindung wird nachfolgend anhand von Zeichnungen näher erläutert.

Es zeigen
- Fig. 1: einen aus einer supraleitenden Platte hergestellten resistiven Strombegrenzer,
- Fig. 2: eine weitere Ausführungsform des erfindungsgemäßen resistiven Strombegrenzers,
- Fig. 3: eine dritte Ausführungsform des erfindungsgemäßen resistiven Strombegrenzers.

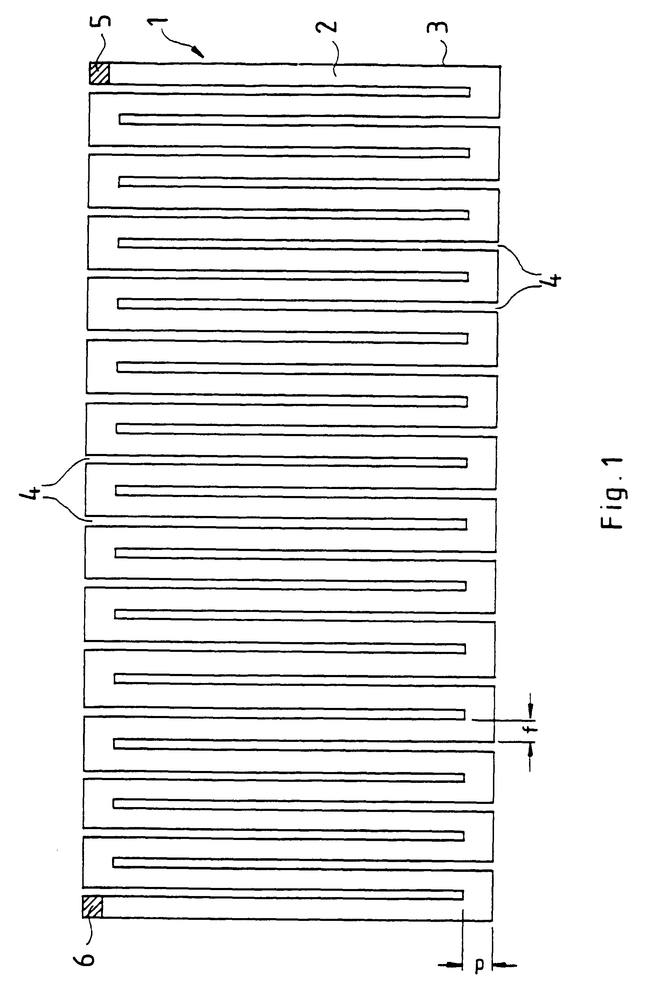

Der in Fig. 1 dargestellte resistive Strombegrenzer 1 weist einen Leiter 2 mit supraleitenden Eigenschaften auf. Der Leiter 2 ist aus einer supraleitenden Platte gefertigt, die bei dem hier gezeigten Beispiel eine orthogonale Form aufweist. Die Platte 3 ist aus YBa₂Cu₃O_{6,9} gefertigt. Sie wird bei einem Druck von 7 kbar verpreßt. Anschließend wird die Platte 3 bei 95o °C etwa 24 Stunden gesintert. Hieran schließt sich eine Abkühlung des Plattenmaterials während 48 Stunden von 9oo auf 4oo °C an. Die Platte 3 weist eine Abmessung von 85 x 5o x 5 mm³ auf. Sie besitzt eine Dichte von 4,69 gxcm⁻³. Dies entspricht einer theoretischen Dichte von 74 %. Die kritische Temperatur dieser Platte 3 liegt bei 89K (R = O Ohm). In die Längsseiten der Platte 3 sind Schlitze 4 eingesägt. Die Schlitze 4 sind alternierend und senkrecht zur Längsachse der Platte 3 angeordnet. Die Schlitze sind so weit in die Platte 3 eingesägt, daß der Abstand d vom Schlitzende bis zur unmittelbar benachbarten Längsseite der Platte 3 etwa so groß ist wie der Abstand f zweier benachbarter Schlitze 4. Dieser beträgt hierbei etwa 2 mm. Hierdurch wird ein mäanderförmiger Leiter 2 gebildet. Der Leiter 2 ist an seinen beiden Enden mit je einem elektrischen Anschlußpol (5, 6) versehen.

Wenn aus Gründen der elektrischen Leitfähigkeit des supraleitenden Materials die Verwendung einer Platte 3 erforderlich ist, die sich nicht selbst trägt, so wird diese zur Erhöhung ihrer Stabilität dauerhaft mit einem Träger (hier nicht dargestellt) verbunden. Dieser kann aus einem isolierenden Material oder einem metallischen Material gefertigt sein. Bei Verwendung eines metallischen Materials wird zwischen die Platte 3 und den Träger (hier nicht dargestellt) ein Isoliermaterial (hier nicht dargestellt) angeordnet. Nach dem Verbinden der Platte 3 mit einem solchen Träger werden die Schlitze 4 wie oben beschrieben ausgebildet. Bei dem hier gezeigten Beispiel sind in die Platte 3 Schlitze 4 mit einer Länge von 4,2 cm und einer Breite von 1 mm eingesägt. Der Abstand zweier benachbarter Schlitze 4 beträgt 2 mm. Der hierdurch gebildete Leiter 2 weist eine Gesamtlänge von 169 cm auf und erfüllt die gewünschte Strombegrenzung in der gewünschten Weise.
Aus der gleichen Platte 3 entsteht, wenn sie mit nur 12 Schlitzen der gleichen Länge versehen wird, ein Leiter mit einer Länge von 67,7 cm. Der ohmsche Widerstand eines solchen Leiters beträgt bei Raumtemperatur 0,70 Ohm. Bei 77 K und einer kritischen Stromdichte von 87 A cm² wird die Supraleitung bei einer Stromstärke von etwa 25 A unterbrochen.

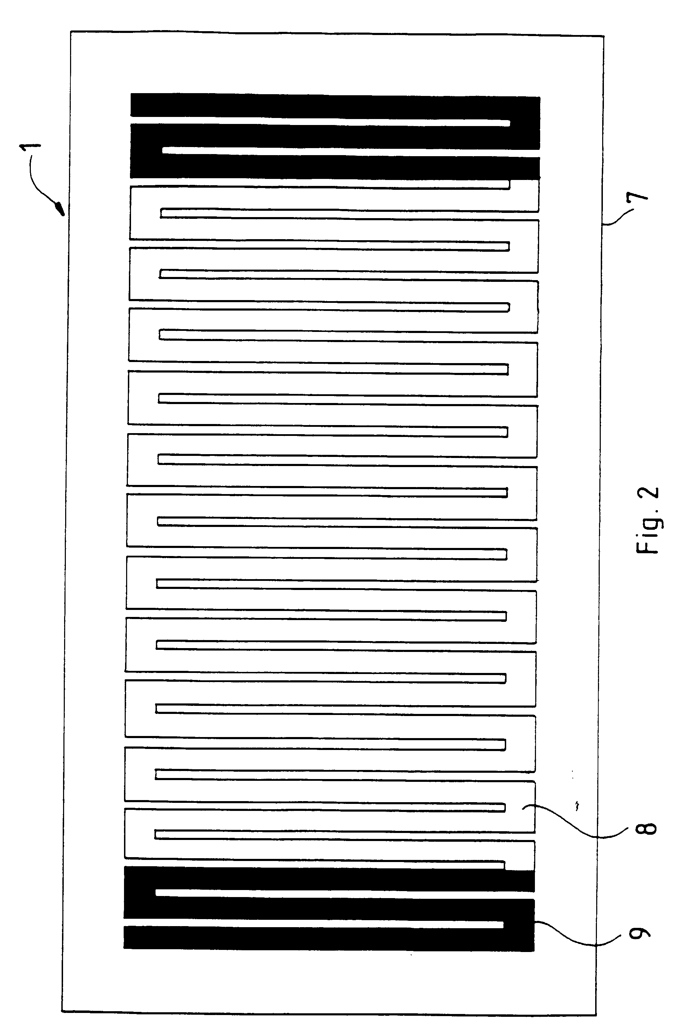

In Fig. 2 ist eine weitere Ausführungsform des erfindungsgemäßen Strombegrenzers 1 dargestellt. Dieser wird hierbei durch einen Träger 7 gebildet, in dessen Oberfläche eine mäanderförmige Nut 8 ausgebildet ist. Diese ist zur Ausbildung des Leiters 2 mit supraleitendem Material 9 ausgefüllt. Die Nut 8 hat, damit der hierdurch gebildete Leiter 2 die gleichen Eigenschaften wie der in Fig. 1 dargestellte und in der zugehörigen Beschreibung erläuterte Leiter 2 auf weist, die gleichen Abmessungen wie der Leiter 2 gemäß Fig. 1. Ist der Träger 7 aus einem elektrisch leitenden Material hergestellt, so wird die Nut 8 zunächst mit einem Isoliermaterial (hier nicht dargestellt) ausgekleidet.

Ist der Träger 7 aus einem isolierenden Material gefertigt, so kann die Nut 8 unmittelbar mit dem Ausgangsmaterial ausgefüllt werden, das später supraleitende Eigenschaften aufweist. Durch eine entsprechende Nachbehandlung erhält dieses Material 9 seine supraleitenden Eigenschaften.

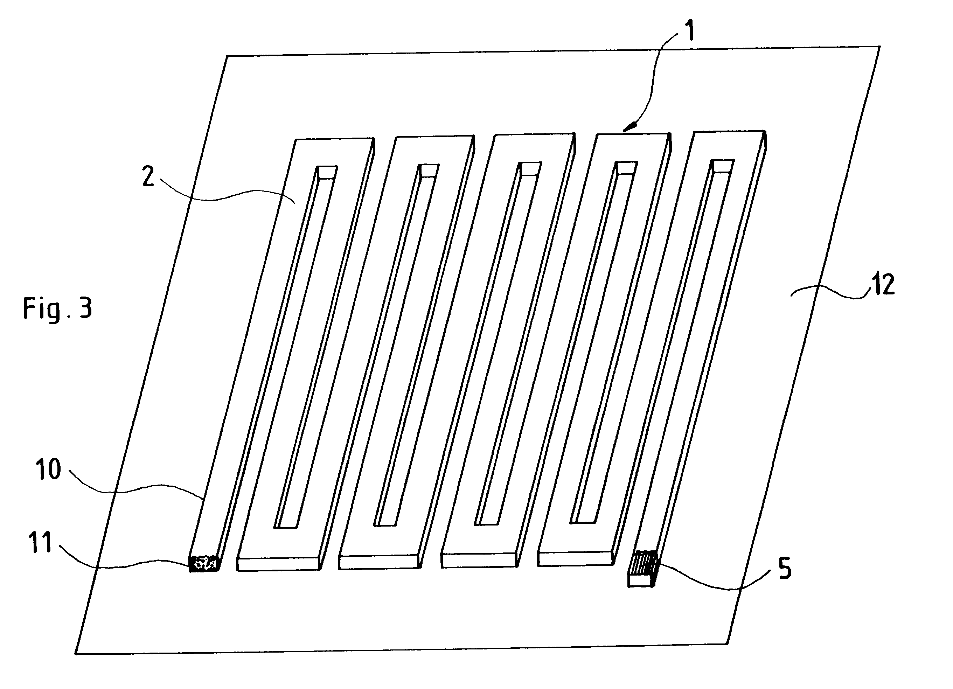

Wie Fig. 3 zeigt, kann der Leiter 2 des Strombegrenzers 1 auch aus einer Hülse 1o gebildet werden, die mit supraleitendem Material 11 ausgefüllt ist. Die Hülse 1o ist so gewalzt und gezogen, daß der Leiter 2 den gleichen Querschnitt wie der in Fig. 1 dargestellte Leiter 2 aufweist. Die Hülse 1o wird zusätzlich so gebogen, daß der Leiter 2 die gewünschte Mäanderform zeigt. Der Leiter 2 weist an seinem einen Ende einen elektrischen Anschlußpol 5 auf. Falls es erforderlich ist, kann die als Leiter 2 dienende Hülse 1o zur Verbesserung der mechanischen Stabilität des Strombegrenzers 1 auf einem Träger 12 aufgebracht sein.

## Patentansprüche (Patentansprüche für folgende(n) Vertragsstaat(en): AT, BE, CH, DE, FR, GB, GR, IT, LI, LU, NL, SE)

1. Resistiver Strombegrenzer mit wenigstens einem den Nennstrom tragenden Leiter aus einem Hochtemperatur-Supraleiter-Material, wobei die elektrisch wirksame Länge des Leiters um mindestens das Dreifache größer ist als seine lineare Ausdehnung, dadurch gekennzeichnet, daß der Leiter (2) mäanderförmig in einer Ebene ausgebildet ist, so daß die Länge des Leiters um mindestens das Dreifache größer ist als die Länge der Ebene, über die sich der Mäander erstreckt und daß der Leiter entweder aus einer supraleitenden Platte mit definierten Abmessungen gefertigt ist oder auf einem plattenförmigen Träger aufgebracht ist.

2. Resistiver Strombegrenzer nach Anspruch 1, dadurch gekennzeichnet, daß die Platte (3) eine orthogonale Form aufweist; daß die Platte (3) zur Ausbildung des Leiters (2) mit Schlitzen (4) versehen ist, welche in definiertem Abstand parallel und alternierend zueinander in die beiden zur Längsachse der Platte (3) verlaufenden Seiten geschnitten sind.

3. Resistiver Strombegrenzer nach Anspruch 1 oder 2, dadurch gekennzeichnet, daß das zur Fertigung des Leiters (2) verwendete Hochtemperatur-Supraleiter-Material ein polynäres Oxid ist, das Bismut, Calcium, Strontium, Kupfer und gegebenenfalls Blei enthält.

4. Resistiver Strombegrenzer nach Anspruch 3, dadurch gekennzeichnet, daß der Leiter (2) aus Bi₂Sr₂CaCu₂0₈ besteht.

5. Resistiver Strombegrenzer nach Anspruch 3, dadurch gekennzeichnet, daß der Leiter (2) aus Bi₂Sr₂Ca₂Cu₃0₁₀ besteht.

6. Resistiver Strombegrenzer nach Anspruch 1 oder 2,, dadurch gekennzeichnet, daß der Leiter (2) aus einem Hochtemperatur-Supraleiter-Material in Form eines polynären Oxids besteht, das Yttrium und/oder ein Seltenerdmetall sowie Barium und Kupfer enthält.

7. Resistiver Strombegrenzer nach Anspruch 6, dadurch gekennzeichnet, daß der Leiter (2) aus YBa₂Cu₃O_{6,9} besteht.

8. Resistiver Strombegrenzer nach Anspruch 1 oder 2, dadurch gekennzeichnet, daß der Leiter (2) aus NbTi besteht.

9. Resistiver Strombegrenzer nach Anspruch 1 oder 2, dadurch gekennzeichnet, daß der Leiter (2) aus Nb₃Sn besteht.

10. Resistiver Strombegrenzer nach Anspruch 1 oder 2, dadurch gekennzeichnet, daß der Leiter (2) aus Chevrel-Phasen besteht.

## Patentansprüche (Patentansprüche für folgende(n) Vertragsstaat(en): ES)

1. Einrichtung zur resistiven Strombegrenzung mit wenigstens einem den Nennstrom tragenden Leiter aus einem Hochtemperatur-Supraleiter-Material, wobei die elektrisch wirksame Länge des Leiters um mindestens das Dreifache größer ist als seine lineare Ausdehnung, dadurch gekennzeichnet, daß der Leiter (2) mäanderförmig in einer Ebene ausgebildet ist, so daß die Länge des Leiters um mindestens das Dreifache größer ist als die Länge der Ebene, über die sich der Mäander erstreckt und daß der Leiter entweder aus einer supraleitenden Platte mit definierten Abmessungen gefertigt ist oder auf einem plattenförmigen Träger aufgebracht ist.

2. Einrichtung nach Anspruch 1, dadurch gekennzeichnet, daß die Platte (3) eine orthogonale Form aufweist; daß die Platte (3) zur Ausbildung des Leiters (2) mit Schlitzen (4) versehen ist, welche in definiertem Abstand parallel und alternierend zueinander in die beiden zur Längsachse der Platte (3) verlaufenden Seiten geschnitten sind. .

3. Einrichtung nach Anspruch 1 oder 2, dadurch gekennzeichnet, daß das zur Fertigung des Leiters (2) verwendete Hochtemperatur-Supraleiter-Material ein polynäres Oxid ist, das Bismut, Calcium, Strontium, Kupfer und gegebenenfalls Blei enthält.

4. Einrichtung nach Anspruch 3, dadurch gekennzeichnet, daß der Leiter (2) aus Bi₂Sr₂CaCu₂0₈ besteht.

5. Einrichtung nach Anspruch 3, dadurch gekennzeichnet, daß der Leiter (2) aus Bi₂Sr₂C_{a,}Cu₃0₁₀ besteht.

6. Einrichtung nach Anspruch 1 oder 2, dadurch gekennzeichnet, daß der Leiter (2) aus einem Hochtemperatur-Supraleiter-Material in Form eines polynären Oxids besteht, das Yttrium und/oder ein Seltenerdmetall sowie Barium und Kupfer enthält.

7. Einrichtung nach Anspruch 6, dadurch gekennzeichnet, daß der Leiter (2) aus YBa₂Cu₃0_{6,9} besteht.

8. Einrichtung nach Anspruch 1 oder 2, dadurch gekennzeichnet, daß der Leiter (2) aus NbTi besteht.

9. Einrichtung nach Anspruch 1 oder 2, dadurch gekennzeichnet, daß der Leiter (2) aus Nb₃Sn besteht.

10. Einrichtung nach Anspruch 1 oder 2, dadurch gekennzeichnet, daß der Leiter (2) aus Chevrel-Phasen besteht.

## Claims (Claims for the following Contracting State(s): AT, BE, CH, DE, FR, GB, GR, IT, LI, LU, NL, SE)

1. Resistive current limiter having at least one conductor of a high-temperature superconductive material, carrying the rated current, the electrically active length of the conductor being at least three times greater than its linear extent, characterised in that the conductor (2) is formed in one plane in the form of a meander, so that the length of the conductor is at least three times greater than the length of the plane over which the meander extends, and in that the conductor is either fabricated from a superconductive plate having defined dimensions or is applied to a plate-shaped carrier.

2. Resistive current limiter according to Claim 1, characterised in that the plate (3) has an orthogonal shape; in that, for forming the conductor (2), the plate (3) is provided with slots (4) which are cut at a defined distance, parallel to and alternating with one another, into the two sides extending with respect to the longitudinal axis of the plate (3).

3. Resistive current limiter according to Claim 1 or 2, characterised in that the high-temperature superconductive material used for fabricating the conductor (2) is a polynary oxide which contains bismuth, calcium, strontium, copper and possibly lead.

4. Resistive current limiter according to Claim 3, characterised in that the conductor (2) consists of Bi₂Sr₂CaCu₂O₈.

5. Resistive current limiter according to Claim 3, characterised in that the conductor (2) consists of Bi₂Sr₂Ca₂Cu₃O₁₀.

6. Resistive current limiter according to Claim 1 or 2, characterised in that the conductor (2) consists of a high-temperature superconductive material in the form of a polynary oxide which contains yttrium and/or a rare-earth metal and barium and copper.

7. Resistive current limiter according to Claim 6, characterised in that the conductor (2) consists of YBa₂CU₃O_{6,9}.

8. Resistive current limiter according to Claim 1 or 2, characterised in that the conductor (2) consists of NbTi.

9. Resistive current limiter according to Claim 1 or 2, characterised in that the conductor (2) consists of Nb₃Sn.

10. Resistive current limiter according to Claim 1 or 2, characterised in that the conductor (2) consists of Chevrel phases.

## Claims (Claims for the following Contracting State(s): ES)

1. Device for resistive current limiting having at least one conductor of a high-temperature superconductive material, carrying the rated current, the electrically active length of the conductor being at least three times greater than its linear extent, characterised in that the conductor (2) is formed in one plane in the form of a meander, so that the length of the conductor is at least three times greater than the length of the plane over which the meander extends, and in that the conductor is either fabricated from a superconductive plate having defined dimensions or is applied to a plate-shaped carrier.

2. Device according to Claim 1, characterised in that the plate (3) has an orthogonal shape; in that, for forming the conductor (2), the plate (3) is provided with slots (4) which are cut at a defined distance, parallel to and alternating with one another, into the two sides extending with respect to the longitudinal axis of the plate (3).

3. Device according to Claim 1 or 2, characterised in that the high-temperature superconductive material used for fabricating the conductor (2) is a polynary oxide which contains bismuth, calcium, strontium, copper and possibly lead.

4. Device according to Claim 3, characterised in that the conductor (2) consists of Bi₂Sr₂CaCu₂O₈.

5. Device according to Claim 3, characterised in that the conductor (2) consists of Bi₂Sr₂Ca₂Cu₃O₁₀.

6. Device according to Claim 1 or 2, characterised in that the conductor (2) consists of a high-temperature superconductive material in the form of a polynary oxide which contains yttrium and/or a rare-earth metal and barium and copper.

7. Device according to Claim 6, characterised in that the conductor (2) consists of YBa₂Cu₃O_{6,9}.

8. Device according to Claim 1 or 2, characterised in that the conductor (2) consists of NbTi.

9. Device according to Claim 1 or 2, characterised in that the conductor (2) consists of Nb₃Sn.

10. Device according to Claim 1 or 2, characterised in that the conductor (2) consists of Chevrel phases.

## Revendications (Revendications pour l'(les) Etat(s) contractant(s) suivant(s): AT, BE, CH, DE, FR, GB, GR, IT, LI, LU, NL, SE)

1. Limiteur de courant résistif comportant au moins un conducteur dans lequel passe le courant nominal et qui est constitué d'un matériau supraconducteur à température élevée, la longueur électriquement efficace du conducteur étant d'au moins trois fois supérieure à son extension linéaire, caractérisé par le fait que le conducteur (2) a, dans un plan, la forme d'un méandre, de façon que la longueur du conducteur soit d'au moins trois fois supérieure à la longueur du plan le long duquel s'étend le méandre et que le conducteur soit soit fabriqué à partir d'une plaque supraconductrice de dimension définie soit rapporté sur un support en forme de plaque.

2. Limiteur de courant résistif selon la revendication 1, caractérisé par le fait que la plaque (3) présente une forme orthogonale; que la plaque (3) est munie, pour former le conducteur (2), de fentes (4) qui sont découpées à distance définie, parallèlement l'une à l'autre et alternativement l'une par rapport à l'autre, dans les deux côtés orientés selon l'axe longitudinal de la plaque (3).

3. Limiteur de courant résistif selon la revendication 1 ou 2, caractérisé par le fait que le matériau supraconducteur à température élevée employé pour la fabrication du conducteur (2) est un oxyde polynaire qui contient du bismuth, du calcium, du strontium, du cuivre éventuellement du plomb.

4. Limiteur de courant résistif selon la revendication 3, caractérisé par le fait que le conducteur (2) est constitué de Bi₂Sr₂CaCu₂O₈.

5. Limiteur de courant résistif selon la revendication 3, caractérisé par le fait que le conducteur (2) est constitué de Bi₂Sr₂Ca₂Cu₃O₁₀.

6. Limiteur de courant résistif selon la revendication 1 ou 2, caractérisé par le fait que le conducteur (2) est constitué d'un matériau supraconducteur à température élevée sous forme d'un oxyde polynaire qui contient de l'yttrium et/ou un métal des terres rares ainsi que du baryum et du cuivre.

7. Limiteur de courant résistif selon la revendication 6, caractérisé par le fait que le conducteur (2) est constitué de YBa₂Cu₃O_{6,9}.

8. Limiteur de courant résistif selon la revendication 1 ou 2, caractérisé par le fait que le conducteur (2) est constitué de NbTi.

9. Limiteur de courant résistif selon la revendication 1 ou 2, caractérisé par le fait que le conducteur (2) est constitué de Nb3Sn.

10. Limiteur de courant résistif selon la revendication 1 ou 2, caractérisé par le fait que le conducteur (2) est constitué de phases de Chevrel.

## Revendications (Revendications pour l'(les) Etat(s) contractant(s) suivant(s): ES)

1. Dispositif pour la limitation résistive du courant comportant au moins un conducteur dans lequel passe le courant nominal et qui est constitué d'un matériau supraconducteur à température élevée, la longueur électriquement efficace du conducteur étant d'au moins trois fois supérieure à son extension linéaire, caractérisé par le fait que le conducteur (2) a, dans un plan, la forme d'un méandre, de façon que la longueur du conducteur soit d'au moins trois fois supérieure à la longueur du plan le long duquel s'étend le méandre et que le conducteur soit soit fabriqué à partir d'une plaque supraconductrice de dimension définie soit rapporté sur un support en forme de plaque.

2. Dispositif selon la revendication 1, caractérisé par le fait que la plaque (3) présente une forme orthogonale; que la plaque (3) est munie, pour former le conducteur (2), de fentes (4) qui sont découpées à distance définie, parallèlement l'une à l'autre et alternativement l'une par rapport à l'autre, dans les deux côtés orientés selon l'axe longitudinal de la plaque (3).

3. Dispositif selon la revendication 1 ou 2, caractérisé par le fait que le matériau supraconducteur à température élevée employé pour la fabrication du conducteur (2) est un oxyde polynaire qui contient du bismuth, du calcium, du strontium, du cuivre éventuellement du plomb.

4. Dispositif selon la revendication 3, caractérisé par le fait que le conducteur (2) est constitué de Bi₂Sr₂CaCu₂O₈.

5. Dispositif selon la revendication 3, caractérisé par le fait que le conducteur (2) est constitué de Bi₂Sr₂Ca₂Cu₃O₁₀.

6. Dispositif selon la revendication 1 ou 2, caractérisé par le fait que le conducteur (2) est constitué d'un matériau supraconducteur à température élevée sous forme d'un oxyde polynaire qui contient de l'yttrium et/ou un métal des terres rares ainsi que du baryum et du cuivre.

7. Dispositif selon la revendication 6, caractérisé par le fait que le conducteur (2) est constitué de YBa₂Cu₃O_{6,9}.

8. Dispositif selon la revendication 1 ou 2, caractérisé par le fait que le conducteur (2) est constitué de NbTi.

9. Dispositif selon la revendication 1 ou 2, caractérisé par le fait que le conducteur (2) est constitué de Nb₃Sn.

10. Dispositif selon la revendication 1 ou 2, caractérisé par le fait que le conducteur (2) est constitué de phases de Chevrel.
